Europäisches Patentamt

European Patent Office

Office européen des brevets

(11) Veröffentlichungsnummer: **0 075 210**
**A2**

(12) **EUROPÄISCHE PATENTANMELDUNG**

(21) Anmeldenummer: **82108332.6**

(22) Anmeldetag: **09.09.82**

(51) Int. Cl.³: **H 05 K 7/02,** H 05 K 7/14,
H 01 R 23/68

(30) Priorität: **22.09.81 DE 3137665**

(71) Anmelder: **SIEMENS AKTIENGESELLSCHAFT, Berlin
und München Wittelsbacherplatz 2,
D-8000 München 2 (DE)**

(43) Veröffentlichungstag der Anmeldung: **30.03.83
Patentblatt 83/13**

(72) Erfinder: **Keller, Roman, Grossenbuch 126,
D-8524 Neunkirchen/Brandt (DE)**
Erfinder: **Assel, Eugen, Hauptstrasse 6,
D-8729 Knetzgau (DE)**

(84) Benannte Vertragsstaaten: **AT BE DE FR GB IT NL SE**

(54) **Baugruppe zum Einschub in einen Baugruppenträger.**

(57) Die Erfindung betrifft eine Baugruppe, mit wenigstens zwei Leiterplatten (2). Damit die einzelnen Leiterplatten (2) und die Bauelemente, mit denen sie bestück sind, für Prüf- und Wartungsarbeiten auch bei hoher Packungsdichte der Bauelemente leicht zugänglich sind, ist jede Leiterplatte (2) als gesonderte Flachbaugruppe (1) mit eigener Griffleiste (3) und gesonderter rückwärtiger Messerleiste (4) ausgebildet. Die Flachbaugruppen (1) sind lösbar mechanisch so miteinander verbunden, dass ihre Griffleisten (3) eine gemeinsame Frontplatte (5) der Baugruppe und ihre Messerleisten (4) die Messerleiste des Steckverbinders der Baugruppe bilden. Die lösbare interne elektrische Verdrahtung der Baugruppe kann über einen Teil (4b) der Messer (4d) der Messerleisten (4) erfolgen, beispielsweise indem die durchkontaktierten Bohrungen (14a) einer kaschierten Leiterplatte (14) auf die Messer (4d) aufgeschoben sind. Bei dieser Baugruppe sind für Prüf- und Wartungsarbeiten lediglich die mechanische Verbindung (6) der einzelnen Flachbaugruppen und gegebenenfalls die internen elektrischen Verbindungsleitungen zu lösen.

SIEMENS AKTIENGESELLSCHAFT
Berlin und München

Unser Zeichen
VPA 81 P 3 1 4 7 E

0075210

## Baugruppen zum Einschub in einen Baugruppenträger

Die Erfindung betrifft eine Baugruppe zum Einschub in einen Baugruppenträger, mit wenigstens zwei Leiterplatten, einer gemeinsamen Frontplatte und einem rückwärtigen gemeinsamen Steckverbinder.

Solche Baugruppen sind unter der Bezeichnung Kompaktbaugruppe, Einsatzbaugruppe oder Kassette aus der DIN 41 639, Teil 4 oder aus der Siemens-Zeitschrift 46 (1972), Seiten 277 bis 279 bekannt.

Bekannt sind aus diesen Literaturstellen auch Flachbaugruppen, die aus einer Leiterplatte bestehen, die mit einer Frontplatte, auch Griffleiste genannt, versehen ist und eine rückwärtige Messerleiste für den Steckverbinder besitzt.

Bei Kompaktbaugruppen sind auf eine Grundleiterplatte Kleinleiterplatten senkrecht aufgebracht, wobei die Kleinleiterplatten wie Bauelemente in die Grundleiterplatte eingelötet oder eine eigene Messerleiste besitzen und in eine eingelötete Federleiste eingesteckt sind. Bei einer engen Anordnung der Kleinleiterplatten wird mit diesem Aufbau eine hohe Packungsdichte erzielt, wobei bei Kompaktbaugruppen mit Federleisten die Kleinleiterplatten bei hohem Aufwand leicht zugänglich sind. Um eine entsprechende Stabilität zu erzielen, ist jedoch für Kompaktbaugruppen bereits ein rahmenartiges Gestell vorzusehen, mit dem die aufgesteckten Kleinleiterplatten umgeben sind und der diese hält.

Soe 2 Bim / 15.09.1981

0075210

Einsatzbaugruppen dienen zum Aufbau größerer und schwerer Funktionseinheiten. Sie bestehen aus einem Rahmen mit teilweise oder vollständiger Verkleidung, in die Norm-Leiterplatten fest eingebaut oder über Steckverbinder eingesetzt sind. Bei fest eingebauten Leiterplatten sind die Bauelemente für Wartungs- und Prüfarbeiten nur schwer zugänglich. Bei steckbaren Leiterplatten sind gesonderte Stecker vorzusehen, die kosten- und volumaufwendig sind.

Kassetten sind schließlich Rahmen mit vollständiger Verkleidung, die zur Aufnahme von Steckplatten geeignet sind. Mit diesen Baugruppen werden sehr große und schwere Funktionseinheiten aufgebaut.

Bei Kompaktbaugruppen, Einsatzbaugruppen und Kassetten ist vorauszusetzen, daß sie konstruktiv so gestaltet sind, daß in ihrem Inneren Baugruppen kontaktiert und gegebenenfalls eingeschoben werden können, um wie bereits betont, die Bauelemente für Wartungs- und Prüfarbeiten zugänglich zu machen. Außerdem sind die Außenabmessungen dieser Baugruppen so festzulegen, daß insbesondere auch die Kassetten in Baugruppenträger eingeschoben werden können und die elektrische Verbindung zur Peripherie und Stromversorgung über eine zentrale Steckverbindung erfolgt.

Es besteht die Aufgabe, eine Baugruppe der eingangs genannten Art so aufzubauen, daß die einzelnen Leiterplatten ohne zusätzlichen Aufwand an Bauelementen für Prüf- und Wartungsarbeiten auch bei hoher Packungsdichte der Bauelemente leicht zugänglich sind.

Erfindungsgemäß wird diese Aufgabe dadurch gelöst, daß jede Leiterplatte als gesonderte Flachbaugruppe mit eigener Griffleiste und gesonderter rückwärtiger Messerleiste ausgebildet ist und daß die Flachbaugruppen

0075210

lösbar mechanisch so miteinander verbunden sind, daß ihre Griffleisten die gemeinsame Frontplatte und ihre Messerleisten die gemeinsame Messerleiste des Steckverbinders bilden.

Bei der erfindungsgemäßen Baugruppe kann die einzelne Leiterplatte durch Lösen der mechanischen Verbindung leicht aus der modularen Funktionsgruppe ausgebaut werden. Zusätzliche Steckverbindungen oder Einschubvorrichtungen wie bei Einsatzbaugruppen und Kassetten sind nicht mehr erforderlich. Auch bei hoher Packungsdichte sind daher die einzelnen Leiterplatten und ihre Bauelemente zugänglich. Außerdem besitzt die erfindungsgemäße Baugruppe eine hohe mechanische Stabilität, ohne daß hierfür gesonderte Rahmen und Verkleidungen vorzusehen sind.

Vorzugsweise sind zur internen Verdrahtung die Leiterplatten der Flachbaugruppen über die zugehörigen Messerleisten lösbar elektrisch miteinander verbunden. Mit dieser lösbaren internen Verdrahtung wird das Ausbauen und Prüfen einzelner Leiterplatten der erfindungsgemäßen Baugruppe weiter erleichert. Besonders vorteilhaft ist es, zur lösbaren elektrischen und mechanischen Verbindung der Flachbaugruppen auf einen Teil der Messer der Messerleisten eine mit durchkontaktierten Bohrungen versehene kaschierte Leiterplatte aufzuschieben. Solche Verdrahtungen über kaschierte Leiterplatten mit durchkontaktierten Bohrungen sind an sich bekannt. Im vorliegenden Fall bietet diese Verdrahtung die Möglichkeit, sowohl die interne Verdrahtung der Leiterplatten der Flachbaugruppen, als auch ihre rückwärtige mechanische Verbindung in einem Arbeitsgang herzustellen und zu lösen. Sowohl die Fertigung als auch die Prüfung und Wartung der erfindungsgemäßen Baugruppe wird damit vereinfacht. Vorzugsweise sind die Messer der Messerleisten, die zur internen Verdrahtung mit einer Leiterplatte vorgesehen sind, als elastische Steckkontakte ausgebildet. Solche elastischen Steckkontakte für Leiterplatten sind beispielsweise aus der DE-OS 23 48 688 bekannt. Da die interne elektrische Verdrahtung der erfindungsgemäßen Baugruppe nur relativ selten gelöst werden muß, lassen sich solche elastische Steckkontakte vorteilhaft einsetzen, da nur eine begrenzte Steckhäufigkeit für die aufgesteckte Leiterplatte notwendig ist.

Zur lösbaren mechanischen Verbindung der Flachbaugruppen kann ein verriegelbarer Verbindungsstift vorgesehen sein, der durch miteinander fluchtende Querbohrungen in den Griffleisten oder durch miteinander fluchtende Querbohrungen in den Messerleisten oder durch miteinander fluchtende Bohrungen in den Leiterplatten gesteckt ist. Insbesondere die lösbare mechanische Verbindung der Griffleisten der Flachbaugruppen zu einer gemeinsamen Frontplatte mittels eines solchen Verbindungsstiftes ist vorteilhaft, da solche Verbindungsstifte auch die an der gemeinsamen Frontplatte angreifende Steck- und Ziehkraft aufnehmen können, die beim Einstecken der Baugruppe in den Baugruppenträger oder beim Herausziehen der Baugruppe aus den Baugruppenträger an der Frontplatte angreift.

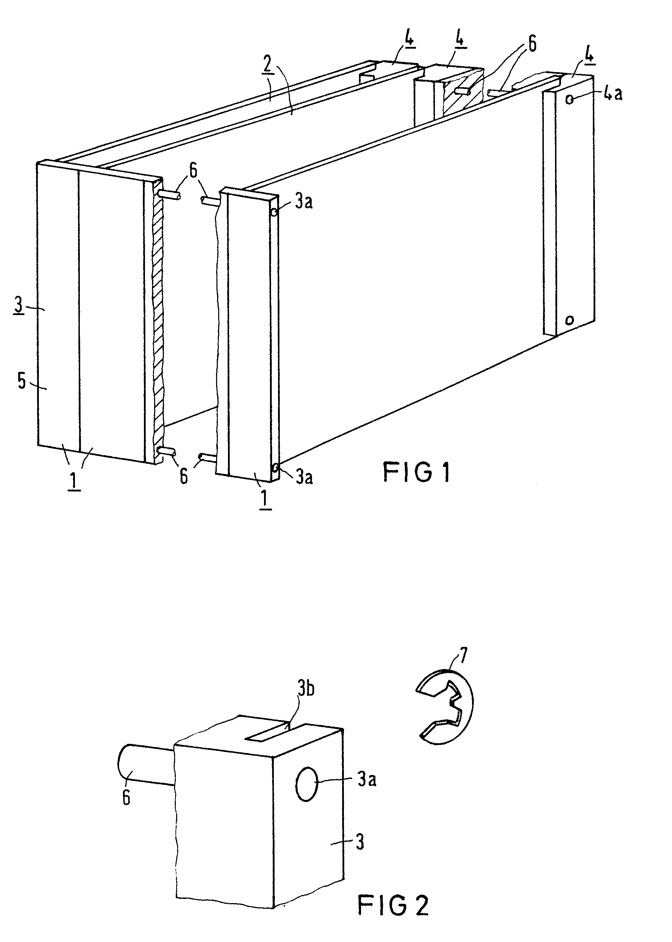

Die erfindungsgemäße Baugruppe wird im folgenden beispielhaft anhand der Figuren 1 bis 5 näher erläutert. Die Figuren zeigen mehrere Ausführungsbeispiele, dabei sind gleiche Bauteile mit den gleichen Bezugszeichen versehen.

Figur 1 zeigt in perspektivischer Ansicht eine erfindungsgemäße Baugruppe. Zu dieser Baugruppe sind mehrere Flachbaugruppen 1 zusammengefügt, wobei zur Demonstration der lösbaren mechanischen Verbindung ein Teil der Flachbaugruppen 1 im Schnitt nicht gezeigt

0075210

ist. Jede der Flachbaugruppen 1 besteht in üblicher
Weise aus einer normierten, kaschierten Leiterplatte 2,
die mit Bauelementen bestückt ist. In der Figur sind
weder die Kaschierung noch Bauelemente gezeigt, um die
Übersichtlichkeit zu wahren. Jede Flachbaugruppe 1 besitzt eine Griffleiste 3 und eine rückwärtige Messerleiste 4, die beim Einschub in den Baugruppenträger in
die Federleiste des Steckverbinders eingreift. Solche
Steckverbinder mit ihren Messer- und Federleisten sind
beispielsweise aus der DIN 41 494 bekannt. Die Flachbaugruppen 1 sind in Figur 1 so zusammengefügt, daß die
Griffleisten 3 eine zusammengesetzte gemeinsame Frontplatte 5 bzw. Frontfläche und die Messerleisten 4 aller
Flachbaugruppen 1 eine kompakte Messerleiste für die
gesamte Baugruppe bilden, die man auch als Kombinationsbaugruppe bezeichnen kann. Zur lösbaren mechanischen
Verbindung der Flachbaugruppen 1 sind im Ausführungsbeispiel nach Figur 1 Querbohrungen 3a in nicht ausgenutzten Bereichen der Griffleisten 3 vorgesehen. Durch
die Querbohrungen 3a ist ein Verbindungsstift 6 geführt,
mit dem die Griffleisten 3 der Flachbaugruppen 1 beispielsweise verschraubt sein können. Auch an der Steckverbinderseite sind die Flachbaugruppen in gleicher
Weise lösbar miteinander verbunden. Hier sind im Ausführungsbeispiel die Messerleisten 4 mit Querbohrungen
4a versehen, die ebenfalls in nicht genutzten Bereichen
der Messerleisten 4 liegen und miteinander fluchten.
Durch die Querbohrungen 4a sind Verbindungsstifte bzw.
-bolzen 6 geführt, die zur lösbaren mechanischen Verbindung der Messerleisten 4 ebenfalls verschraubt sein
können. Mit dieser einfachen lösbaren mechanischen
Befestigung der einzelnen Flachbaugruppen 1 aneinander
erhält man eine mechanisch sehr stabile Baugruppe, für
die weitere mechanische Versteifungsmittel, beispielsweise gesonderte Rahmen nicht erforderlich sind. Außerdem läßt sich die mechanische Verbindung der Flachbaugruppen 1 leicht lösen, so daß die einzelnen

0075210

Flachbaugruppen 1 und ihre Bauelemente für Prüfungs- und Wartungszwecke ohne besonderen Zeit- und Bauteileaufwand zugänglich sind. Zu erwähnen ist ferner noch, daß die in Figur 1 gezeigte Baugruppe fertigungsfreundlich ist, da die einzelnen Flachbaugruppen 1 in der üblichen Serienfertigung für Flachbaugruppen hergestellt werden können, ohne daß hierzu eine Änderung im Arbeitsablauf in der Größe der Leiterplatten, der Griffleisten und der Steckverbinder erforderlich ist, was zumindest die Lagerhalterung vereinfacht.

Figur 2 zeigt eine besonders günstige Ausführungsform für die Verriegelung der Verbindungsstifte bzw. -bolzen 6. Die Figur 2 zeigt eine Ecke einer Griffleiste 3 mit der Querbohrung 3a in die ein Verbindungsstift 6 eingeführt ist. In der Griffleiste 3 ist ein quer verlaufender Schlitz 3b angeordnet, der die Querbohrung 3a umfaßt. In den Schlitz 3b kann ein Sicherungselement 7 eingeführt werden, das in eine Ringnut des Verbindungsstiftes 6 einschnappt und damit die lösbare Verriegelung des Verbindungsstiftes 6 bewirkt. Diese Verriegelung mit dem Sicherungselement 7 ist nicht nur leicht lösbar, sondern sie vermeidet auch seitlich von der Baugruppe abstehende Teile, beispielsweise Muttern, die bei der Breite der Einbauplätze der Baugruppe im Baugruppenträger berücksichtigt werden müßten. Selbstverständlich kann eine ähnliche Verriegelung auch bei den Messerleisten 4 vorgenommen werden, wobei ebenfalls lediglich Schlitze, die bis zur Querbohrung 4a reichen, vorzusehen sind. Solche Schlitze lassen sich, an vorgegebener Stelle bereits bei der Fertigung sowohl der Griffleisten 3, als auch der Messerleisten 4 ohne weiteren Aufwand realisieren.

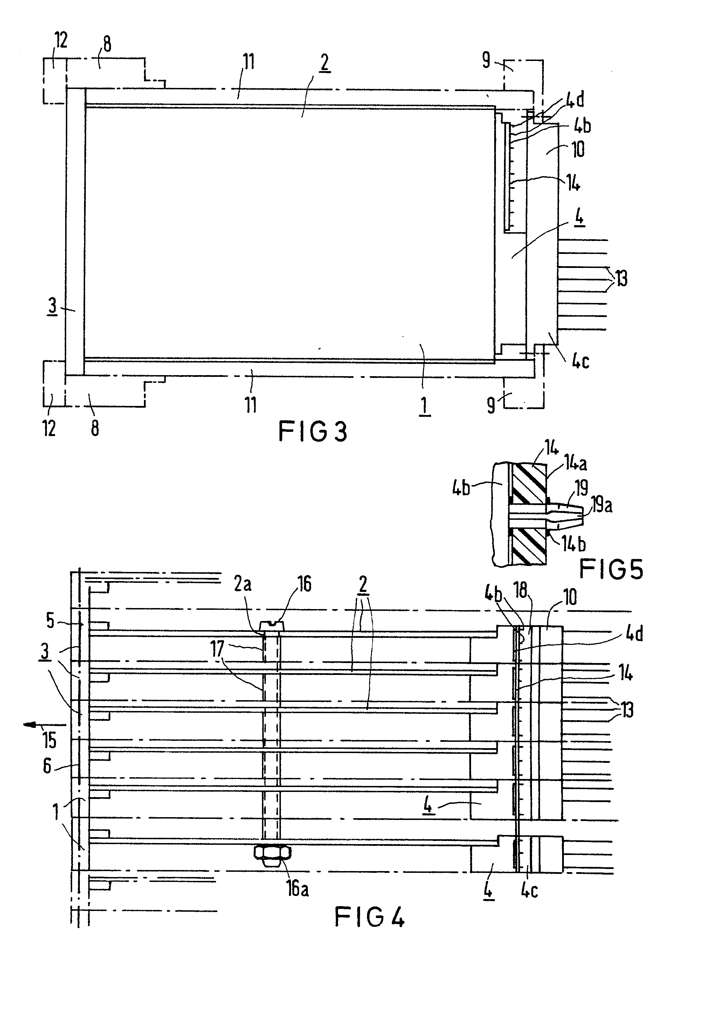

Figur 3 zeigt die äußere Flachbaugruppe 1 einer erfindungsgemäßen Baugruppem im Aufriß. Dabei ist die Baugruppe in einen Baugruppenträger eingeschoben, von dem

0075210

die vorderen Querprofile 8, die hinteren Querprofile 9 und die Federleiste 10 schematisch angedeutet sind. Die Baugruppe wird im Baugruppenträger mit Führungsleisten 11 in üblicher Weise geführt, wobei für jede Flachbaugruppe 1 der Baugruppe gesonderte Führungsleisten 11 vorgesehen sein können. Im Baugruppenträger ist die Baugruppe mit Verriegelungsschienen 12 verriegelt, die die oberen und unteren Kanten der Frontplatte 5 der Baugruppe überdecken. Beim Ausführungsbeispiel nach Figur 3 sind die Messerleisten 4 jeder Flachbaugruppe 1 in zwei Teilbereiche 4b und 4c unterteilt. Der Sockel des Messerleistenteils 4c liegt an der Federleiste 10 an und seine Messer greifen in die Federleiste ein, womit die elektrische Verbindung der Baugruppe mit dem rückwärtigen Stachelfeld 13 der Federleiste 10 hergestellt wird. Das Stachelfeld 13 kann zur peripheren elektrischen Verbindung der Baugruppe beispielsweise im Wire-Wrap-Verfahren verdrahtet werden. Der Sockel des Messerleistenteils 4b ist flacher und seine Messer 4d greifen nicht in die Federleiste ein. Diese Messer 4d sind zur internen, lösbaren elektrischen Verdrahtung der Baugruppe vorgesehen. Diese lösbare elektrische Verdrahtung der Leiterplatten 2 der Flachbaugruppen untereinander kann beispielsweise mit über Steckern an den Messern 4d befestigten Leitungen erfolgen. Bewährt hat es sich, diese Verdrahtung mit einer gesonderten, kaschierten Leiterplatte 14 vorzunehmen, die durchkontaktierte Bohrungen aufweist, in die die Messer 4d eingreifen. Bei der beschriebenen Baugruppe bietet diese interne Verdrahtung mit einer kaschierten Leiterplatte 14 einerseits den Vorteil, daß die Verdrahtung mit begrenzter Häufigkeit leicht lösbar ist, andererseits dient die Leiterplatte gleichzeitig zur rückwärtigen, lösbaren mechanischen Verbindung der Flachbaugruppen 1 untereinander, so daß zumindest einer der in Figur 1 gezeigten Verbindungsstifte 6 im Bereich der Messerleisten 4 entfallen kann.

Figur 4 zeigt eine Draufsicht, auf die im Zusammenhang mit Figur 3 beschriebene Baugruppe, die im Ausführungsbeispiel als Kombinationsbaugruppe aus sechs Flachbaugruppen 1 zusammengesetzt ist. Die Querprofile 8 und 9 des Baugruppenträgers wurden weggelassen, um die Übersichtlichkeit zu wahren. Die Figur 4 demonstriert, wie mit der auf die Messer 4d des internen Verdrahtungsbereiches 4b der Messerleiste 4 aufgeschobene Leiterplatte 14 eine einfache interne Verdrahtung aller Flachbaugruppen 1 und eine einfache rückwärtige mechanische Verbindung bewirkt wird. Außerdem zeigt die Figur schematisch den Verbindungsstift 6, der durch die Querbohrungen 3a der Griffleisten 3 geführt ist und die frontseitige, mechanische Verbindung der Flachbaugruppen 1 und die Verbindung ihrer Griffleisten 3 zur gemeinsamen Frontplatte 5 bewerkstelligt. Mit diesen Verbindungsstiften 6 kann auch eine Zugkraft in Richtung des Pfeiles 15 aufgenommen werden, die zum Ziehen der Baugruppe aus dem Baugruppenträger erforderlich ist. Eine weitere, mechanische Verbindungsmöglichkeit für die Flachbaugruppen 1 ist mit der Schraube 16 angedeutet, die durch miteinander fluchtende Bohrungen 2a in den Leiterplatten 2 geführt und mit einer Mutter 16a verschraubt ist. Um die mechanische Stabilität der lösbaren mechanischen Verbindung zu erhöhen, können zwischen den Leiterplatten Abstandshalter 17 eingefügt sein.

Figur 5 zeigt in vergrößerter Darstellung den mit dem Kreis 18 in Figur gekennzeichneten Bereich. Bei dieser Ausführungsform sind die Messer 4d des internen Verbindungsbereiches 4b der Messerleisten 4 der Flachbaugruppen 1 durch einen Steckkontakt 19 ersetzt. Der Steckkontakt 19 besteht im Ausführungsbeispiel aus einem zylindrischen Teil, an den sich ein wulstartiger Teil anschließt, dessen Durchmesser größer als der zylindrische Teil ist. Die Länge des zylindrischen Teils entspricht etwa der Dicke der Leiterplatte 14. Der kegelstumpfartige Teil verjüngt sich gegen das Ende des Steckkontaktes. Der gesamte Kontaktstift weist einen Längsschlitz 19a auf, der ein radiales federndes Verhalten des Steckkontaktes bewirkt. Beim Einführen des Steckkontaktes 19 in die durchkontaktierte Bohrung 14a der Leiterplatte 14 wird der Steckkontakt konzentrisch zusammengedrückt und kann durch die Bohrung 14a gesteckt werden. Der wulstartige Teil des Steckkontaktes weitet sich nach dem Durchsetzen der Bohrung auf seinen ursprünglichen Durchmesser aus und hintergreift die Leiterplatte 14. Dadurch wird ein mechanisch fester und lösbarer Sitz des Steckkontaktes 19 in der Bohrung 14a erreicht. Wegen des federnden Verhaltens des Kontaktstiftes 19 wird dieser in der Bohrung 14a fest an die Durchkontaktierung 14b angedrückt, womit man eine gute, lösbare elektrisch leitende Verbindung des Kontaktstiftes mit den Verbindungsleitungen der Leiterplatte 14 erhält.

5 Figuren
7 Patentansprüche

Patentansprüche

1. Baugruppe zum Einschub in einen Baugruppenträger, mit wenigstens zwei Leiterplatten, einer gemeinsamen Frontplatte und einem rückwärtigen, gemeinsamen Steckverbinder, d a d u r c h g e k e n n z e i c h - n e t , daß jede Leiterplatte (2) als gesonderte Flachbaugruppe (1) mit eigener Griffleiste (3) und gesonderter rückwärtiger Messerleiste (4) ausgebildet ist und daß die Flachbaugruppen (1) lösbar mechanisch so miteinander verbunden sind, daß ihre Griffleisten (3) die Frontplatte (5) und ihre Messerleisten (4) die Messerleiste des gemeinsamen Steckverbinders bilden.

2. Baugruppe nach Anspruch 1, d a d u r c h g e k e n n z e i c h n e t , daß zur internen Verdrahtung die Leiterplatten (2) der Flachbaugruppen (1) über die zugehörigen Messerleisten (4d) lösbar elektrisch miteinander verbunden sind.

3. Baugruppe nach Anspruch 1 und 2, d a d u r c h g e k e n n z e i c h n e t , daß zur lösbaren elektrischen und mechanischen Verbindung der Flachbaugruppen (1) auf einem Teil (4b) der Messer (4d) der Messerleisten (4) eine mit durchkontaktierten Bohrungen (14a) versehene, kaschierte Leiterplatte (14) aufgeschoben ist.

4. Baugruppe nach Anspruch 3, d a d u r c h g e k e n n z e i c h n e t , daß die Messer (4d) der Messerleisten (4) die zur internen elektrischen Verbindung vorgesehen sind, als elastische Steckkontakte (19) ausgebildet sind.

5. Baugruppe nach einem der Ansprüche 1 bis 4, d a - d u r c h g e k e n n z e i c h n e t , daß zur lösbaren mechanischen Verbindung der Flachbaugruppen (1)

0075210

ein verriegelbarer Verbindungsstift (6) vorgesehen ist, der durch miteinander fluchtende Querbohrungen (3a) in den Griffleisten (3) gesteckt ist.

6. Baugruppe nach einem der Ansprüche 1 bis 5, d a d u r c h   g e k e n n z e i c h n e t ,   daß zur lösbaren mechanischen Verbindung der Flachbaugruppen (1) ein verriegelbarer Verbindungsstift (6) vorgesehen ist, der durch miteinander fluchtende Querbohrungen (4a) in den Messerleisten (4) gesteckt ist.

7. Baugruppe nach einem der Ansprüche 1 bis 6, d a d u r c h   g e k e n n z e i c h n e t ,   daß zur lösbaren mechanischen Verbindung der Flachbaugruppen (1) ein verriegelbarer Verbindungsstift (16) vorgesehen ist, der durch miteinander fluchtende Bohrungen (2a) in den Leiterplatten (2) gesteckt ist.

FIG 1

FIG 2

FIG 3

FIG 5

FIG 4